# EUROPEAN PATENT APPLICATION

(11) **EP 4 474 945 A1**
(43) Date of publication of application: **11.12.2024**
(21) Application number: 23177996.8
(22) Date of filing: 07.06.2023
(51) Int. Cl.: G06F 1/18, G06F 1/20, H01L 23/467

(54) **A MULTIPART COOLING MODULE FOR COOLING A RUGGED COMPUTER AND A METHOD FOR ITS MANUFACTURING**

(71) Applicant: HENSOLDT Sensors GmbH, 82024 Taufkirchen (DE)
(72) Inventor: Schaufler, Andreas, 89264 Weissenhorn (DE); Fueller, Manuel, 89073 Ulm (DE); Mudrak, Dominic, 89250 Senden (DE)
(74) Representative: LifeTech IP Spies & Behrndt Patentanwälte PartG mbB

(57) **Abstract**

A multipart cooling module (100) for cooling a chip (10) of a rugged computer is disclosed. The multipart cooling module (100) comprises: a first frame (no) configured to take heat from the chip (10) of a rugged computer by providing a mounting structure (115) to mount the first frame (110) in thermal contact with the chip (10); a second frame (120) configured to dissipate the heat taken from the first frame (110); and heat pipes (130), thermally connecting the first frame (110) and second frame (120) to transfer the heat taken from the first frame (110) to the second frame (120).

## Description

The present invention relates to a multipart cooling module for cooling a chip of a rugged computer, a method for manufacturing the multipart cooling module, and, in particular, to a multipart cooling frame for improvement of thermal behavior of rugged conduction cooled computer modules used for example in industrial, avionic, maritime or military applications.

### BACKGROUND

Electronic devices are developed with more and more performance and at the same time produce more and more waste heat. As a consequence, cooling solutions are needed that are able to transfer more and more excess heat away from the electronics.

In recent years the amount of compute power integrated into a single electronic component has increased significantly. As a consequence, it becomes mandatory to improve cooling solutions to extract waste heat while at the same time conforming to certain regulations, for example environmental standards.

To a certain extent the overall compute performance achieved by CPUs, FPGAs, GPUs and other electronic computing devices is defined by their operational temperature.

For example, the VMEbus International Trade Association (VITA) promotes concepts of open technology for critical embedded computing as embodied in the standards under development within VITA. The VITA name is synonymous with open systems and is accredited as an American National Standards Institute (ANSI) developer to provide ANSI/VITA standards.

In conventional ANSI/VITA rugged conduction cooled compute modules, monolithic aluminum heatsinks or, in some cases, mixed-metal heatsinks based on copper and aluminum are utilized.

Due to a cascade of manufacturing tolerances of the electronic chip, the chip packaging, the soldering process, and machining of the heatsinks, there is a need to use thick Thermal Interface Material (TIM) between the chip and the heatsink. The thicker the TIM, typically the higher the thermal resistance between the chip and the heatsink. This, however, will lead to worse thermal conduction compared to a thinner TIM.

Therefore, there is a demand for the overcoming of these limitations imposed by the cascade of tolerances described above.

### SUMMARY OF THE INVENTION

At least some of the problems as described before are overcome by a multipart cooling module of claim 1, a rugged computer device comprising the multipart cooling module of claim 10, or a method for manufacturing a multipart cooling module according to claim 14. The dependent claims refer to further advantageous realizations of the subject matters defined in the independent claims.

The present invention relates to multipart cooling module for cooling a chip of a rugged computer. The multipart cooling module comprises: a first frame configured to take heat from the chip of a rugged computer by providing a mounting structure to mount the first frame in thermal contact with the chip, a second frame configured to dissipate the heat taken from the first frame. The multipart cooling module further comprises heat pipes, thermally connecting the first frame and second frame to transfer the heat taken from the first frame to the second frame.

The second frame may cover a larger area than the first frame to support the heat dissipation at the second frame. The second frame can be thermally connected to heatsinks to enhance thermal performance and to create additional heat transfer paths from the chip to the chassis of the rugged computer. Thus, the rugged computer may be a rugged conduction cooled computer (and not a forced convection cooled computer).

The chip can be the primary heat source of the rugged computer. However, the computer may include one or more highly dissipative electronic components.

Optionally, the rugged computer comprises a printed circuit board (PCB) and the mounting structure may be configured to secure or mount the first frame to the printed circuit board. The multipart cooling module may further comprise a stiffener, mountable on the printed circuit board. The stiffener may be configured to engage the mounting structure to stiffen the printed circuit board when securing the first frame.

The stiffener may be mounted on a rear side of the PCB which is opposite to a side on which the chip and/or the first frame is mounted. Thus, the front side of the printed circuit board can be defined as the side on which the mounting of the first frame will be established.

It is understood that the printed circuit board and/or the chip are not part of the multipart cooling module. The printed circuit board and/or the chip can be any type, but are especially suitable for a rugged computer. The stiffener can be a plate that further stabilizes the first frame and avoids bending of the printed circuit board during mounting. The stiffener can be made for example of rigid steel or a stiff dielectric material (e.g. a plastic).

Optionally, the mounting structure can be formed to provide a gap to the printed circuit board when mounted on the printed circuit board. The gap has the technical effect to compensate for manufacturing tolerances of the chip and/or the printed circuit board.

In addition, since the rugged computer is designed to operate under harsh environment conditions (e.g. high and low temperatures) the gap may mitigate thermal stresses applied on the mounted cooling module when fixed in place using springs. Springs can be for example disc springs to close tolerances, in particular springs that comply with DIN 2093.

Optionally, the first frame may comprise a thermal contact surface to provide a plane-parallel contact to the chip through a thermal interface material (TIM) when the multipart cooling module is mounted on the printed circuit board.

It is understood that the thermal contact surface is part of the first frame. For example, the thermal contact surface is in direct contact with the chip through the thermal interface material.

It is understood that the thermal interface material may be in full contact with the chip and there is no air gap between the two components. The thermal interface material may be located between the thermal contact surface and the chip. In addition, the thermal interface material can also made of a high-performance thermal interface material. For example, the thermal contact surface is in plane-parallel contact with the chip to cool through a TIM.

In addition, the thermal contact surface can be optimized for thermal transition by reducing surface ripple and roughness of the first frame using well established manufacturing processes.

Due to the tolerance compensation capabilities of the multipart cooling module, the TIM can be much thinner and therefore of higher thermal performance.

Optionally, the mounting structure can be adapted to provide a detachable connection selected from one of the following: a screw connection, a clip connection, a bayonet, a spring mounted connection. Hence, the printed circuit board and/or the stiffener may comprise holes through which screws or studs or clips may extend to engage with the mounting structure.

The gap between the detachable first frame and the printed circuit board can be adjusted to compensate for manufacturing tolerances in the height and tilt introduced by the soldering balls during the soldering process, the machining of the frame, and the chip/package itself to ensure the desired plane-parallel direct contact.

Optionally, the first frame and/or the second frame include a soldering material, in which the heat pipes are embedded. The technical effect of the soldering material is, at first, to position the heat pipes. In addition, the presence of the solder between the first frame and the heat pipes, or between the second frame and the heat pipes, may provide an interface which can aid in providing a good thermal connection. The heat pipes can be completely surrounded with the soldering material (e.g. no air gap between the heat pipes and the first frame and/or the second frame).

According to embodiments, the heat pipes are not completely rigid. i.e. they can compensate height differences between the first frame and the second frame. Height differences can occur due to manufacturing tolerances of electronic components, the soldering process and machining of the frame part itself.

Optionally, the mounting structure is formed to protrude parallel to the heat pipes. In addition, the heat pipes may be bent to diverge into a larger area, for example at the second frame. The protruding form of the mounting structure has the technical effect to support this bending of the heat pipes without risking damages at the first frame or the printed circuit board (e.g. providing a bending edge).

Elements that support vibration resistance while still ensuring the thermal contact between the first frame and the chip can be:
- strictly torque controlled fastening of screws;
- torquing of screws relative to their maximum torque;
- fixation of screws such that they cannot get loose during vibration using screw lock or locking fasteners;
- spring-loaded mounted e.g. using disc springs;
- other shock-absorbers.

In addition, or alternatively, to the soldering material, vibration absorbing spacer elements can be arranged between the heat pipes to maintain a reliable heat dissipation by the multipart cooling module even in harsh environment. The vibration absorbing spacer elements may help to hold the heat pipes in place when exposed to sinusoidal or random vibrations at different frequencies or to random impulses.

Optionally, the second frame is one of multiple second frames. For example, the multiple second frames may be configured to cover different heatsinks, and different heatsinks may be configured to couple to different fasteners of the rugged computer. For example, the number of the second frames may be the same as the number of the heatsinks and the number of the fasteners.

Optionally, the material of the first frame is copper or another highly thermally conductive material and the material of the second frame is aluminum or an aluminum alloy or another thermally conductive material. Using different materials for the first frame and the second frame allows to determine the optimum balance between mass/weight and thermal performance.

Embodiment also relate to a rugged computer device (configured) for an industrial computer, a military grade computer, an avionic computer, a maritime computer, a space based or any other computing device required to operate under harsh environmental conditions.

The rugged computer device may comprise one or multiple printed circuit boards with electronic components, at least one chip, a housing, and multipart cooling module(s) as described before. The housing of the rugged computer optionally may act as a heat sink releasing the heat passively or actively in the environment or any other active heat exchanging device.

It is understood that the rugged computer device is not designed for exclusive use in a controlled environment (e.g. an office computer or server computer in an air conditioned environment). The term "rugged computer" should be understood as a computer that remains fully operational even in a harsh industrial or military environment (e.g. during rain, direct sun exposure, environment temperatures of above 50°C, constant vibrations on vehicles or airborne devices, shock, dirt, mud, salt, fog etc.). According to another embodiment, the rugged computer device is configured for any type of industrial, aerospace, maritime, space based or military computer that must operate under harsh environmental conditions. According to another embodiment, the rugged computer device can be robust and able to withstand harsh environments, like strong vibrations, extreme temperatures (above 50°C or as low as -40°C), and wet or dusty condition or any other outdoor environment.

According to another embodiment, the rugged computer device is configured to withstand exposure to up to 95% relative humidity. In addition, according to another embodiment, the rugged computer device is also configured to operate even at very high to extreme altitudes, for example from 460 meters (1,500 feet) below sea level to 18,300 meters (60,000 feet) above sea level.

In contrast, the above mentioned extreme operating environments are not suitable for the conventional computer module (e.g. office computer or gaming computer). The high level of relative humidity can cause internal components to rust and reduce the electrical resistance or thermal conductivity. For example, the high level of humidity (e.g. >80%) can cause the conventional computers to short circuit. Likewise, high altitude can cause system failure, and the tolerated altitude below and above sea level is very limited (e.g. -15 m to 3,000 m).Optionally, the rugged computer device may comprise one or more of the following components:
- one or more heatsinks;
- one or more fasteners;
- connectors.

The one or more heatsinks may be arranged on one or more edges of the printed circuit board and the second frame is adapted to thermally contact the heatsink(s).

The one or more fasteners may be arranged at one or more edges of the printed circuit board. For example, the fasteners are adapted to thermally and mechanically contact the one or more heatsinks to the printed circuit board. The heatsink may provide a way to attach a fastener (e.g. wedgelock). It is understood, that the fastener (e.g. wedgelock) itself is a separate component of the rugged computer device.

The rugged computer device may further comprise connectors, arranged on an edge of the printed circuit board. The connectors may provide the electrical connection to/from the components on the printed circuit board (e.g. signal lines, power supply etc.). For example, the one or more heatsinks and the connectors can be provided at distinct edges of the printed circuit board.

Heatsinks may be adapted to dissipate the internally generated heat, facilitate heat transfer, and improve cooling of the electronic components. The heatsink can also have a robust design and construction. For example, the heatsink may extend longitudinally along the edges of the printed circuit board.

The technical function of the heatsink is to improve heat dissipation by receiving heat from a component that generates heat, for example the chip and other electronic components. According to embodiments, the rugged conduction cooled computer module may dissipate all generated heat through the heat sinks without a need of any kind of forced convection cooling.

Optionally, the rugged computer device may be configured to comply with at least one of the following standards for embedded computing systems: the VITA 47 group of standards, DO-160, MIL-STD 810 or other standards by including at least one of the following:
- forming the heatsink without relying on forced ventilation for cooling (e.g. forced convection cooling);
- forming the first frame out of highly conductive material with a thickness of at least the diameter of the heat pipes;
- forming the thermal contact surface on the first frame;
- forming the thermal interface material between the thermal contact surface and the chip or other electronic components;
- using thin, high performance thermal interface material on the thermal contact surface between the first frame and the chip to cool the chip;
- forming the thermal contact surface in direct contact with the chip through the thermal interface material;
- forming the heat pipes to operate with temperatures at the heatsink of more than 50°C or more than 70°C;
- using a mounting structure for the multipart cooling module that withstand shocks (e.g. 40 g, 11 ms) and/or half-sine vibrations: 0.1 g²/Hz, 5-2000Hz, and/or high relative humidity (up to 95%), and/or high g-forces in any direction (g earth acceleration) .

Further embodiments relate to industrial, avionic, maritime, space or military system that comprises the rugged computer device as described before. The rugged computer device includes the multipart cooling module and can improve the industrial, avionic, maritime, space or military system performance under a wide range of temperature and diverse and harsh environmental conditions.

Harsh environmental conditions can be simulated within laboratory conditions. If verification is accomplished by test, then testing shall be accomplished in accordance with environmental standards. The laboratory tests and simulations can include:
- operating shock for conduction-cooled plug-in units (e.g. rugged computer device). The plug-in unit shall withstand exposure to either 40g, 11 millisecond shock half-sine; or 40g, 11 millisecond, terminal sawtooth shock pulses in all three axes. For example, the selection of half sine or terminal sawtooth pulses is made by the plug-in unit vendor.
- vibration for conduction (e.g. Class V3) plug-in units (e.g. rugged computer device). The plug-in unit can withstand vibration as defined below for 1 hour per axis:
   ∘ 5 Hz to 100 Hz PSD (power spectral density) increasing at 3 dB/octave;
   ∘ 100 Hz to 1000 Hz PSD = 0.1 g2/Hz;
   o 1000 Hz to 2000 Hz PSD decreasing at 6 dB/octave.
- allowable edge temperature for conduction cooled plug-in unit (e.g. rugged computer device). Plug-in unit temperature, on the surface of the edge that contacts the rack/enclosure, for operating conduction cooled plug-in units can be within the limits shown below:
   o from 0°C to 55°C;
   o from -40°C to 55°C;
   o from -40°C to 70°C;
   o from -40°C to 85°C.

According to an embodiment, the rugged computer device can achieve the highest level of allowable edge temperature (from -40°C to 85°C) on higher power chips than common approaches.

According to another embodiment, the rugged computer device further can meet the following relevant environmental condition:
- Humidity: the plug-in unit (e.g. rugged computer device), oriented vertically, can withstand exposure up to 95% relative humidity (RH) for five 48-hour cycles.

It is understood that humidity is 95 ± 4% RH throughout test except cooling descending temperature periods when RH may drop to 85%. Performance is measured under conditions of 30°C and 95% RH. Test item is otherwise non-operating.

According to another embodiment, the rugged computer device further can meet the following relevant environmental condition:
- Altitude: the plug-in unit (e.g. rugged computer device) can operate at altitudes from 1,500 feet (460 meters) below sea level to 60,000 feet (18,300 meters) above sea level.

It is understood that the above describe environmental conditions (e.g. shock, vibration, edge temperature, humidity, altitude) within the relevant ranges are not met by a commercial grade computer like found in an office or server room.

Further embodiments relate to a method for manufacturing a multipart cooling module for cooling a chip of a rugged computer. The method comprises at least one of the following step:
- providing a first frame with a mounting structure to mount the first frame in thermal contact with the chip of the rugged computer;
- providing a second frame and heat pipes; and
- thermally connecting the first frame and second frame with heat pipes to transfer the heat taken from the first frame to the second frame.

Optionally, the method for manufacturing further comprises at least one of the following step:
- embedding the heat pipes in soldering material in the first frame;
- embedding the heat pipes in (further) soldering material in the second frame;
- embedding the heat pipes in other high thermal conductive materials like paste, TIM or thermal glue.

When comparing to conventional systems, embodiments of the present multipart cooling module provide the following advantages. Although any cooling module can be used for cooling a chip, currently there is no multipart cooling module suitable for a rugged computer module like an ANSI/VITA compliant computer module available that has several independent parts which are loosely coupled. This provides the further advantage that adaptions to different computer systems can easily be made.

A rugged conduction cooled computer modules can be for example ANSI/VITA compliant computer modules.

Since the components of the rugged computer are usually exposed to harsh environment and severe vibrations, the cooling of the electronic components depends on the effective heat extraction under such conditions. According to embodiments, heat pipes are utilized for the transfer of the thermal energy from the heat source (e.g. chip) through the multipart cooling module to heatsinks.

Therefore, embodiment of the present multipart cooling module, provide an optimized heat transfer so that rugged conduction cooled computer modules are able to operate in harsh environmental conditions e.g. in an industrial context or aerospace or space grade and defense grade computer modules. Embodiments achieve improvement in the heat transfer by providing a multipart cooling module for a rugged computer, which includes a loosely coupled first frame and multiple second frames and a loose coupling between the first frame and the second frames via heat pipes.

The desired effect is further achieved by locating the most significant electronic component to cool (e.g. the chip) below the first frame to dissipate the generated waste heat. In addition, secondary electronic component(s) can be located below any of the second frame. This provides the advantage that the electronic components are properly cooled and the generated excess heat is dissipated effectively.

### BRIEF DESCRIPTION OF THE DRAWINGS

Some embodiments of the present invention will be described in the following by way of examples only, and with respect to the accompanying figures, in which:
- Fig. 1A: shows a schematic arrangement of a multipart cooling module on a printed circuit board according to an embodiment;
- Fig. 1B: shows a schematic arrangement of a multipart cooling module on a printed circuit board according to another embodiment;
- Fig. 2: shows an exemplary arrangement of the multipart cooling module and other components on the front side of a printed circuit board;
- Fig. 3: shows an exemplary arrangement of the components on the rear side of a printed circuit board;
- Fig. 4A: shows a side view of the multipart cooling module on the printed circuit board;
- Fig. 4B: shows an exemplary arrangement of rear side of the multipart cooling module;
- Fig. 5A: shows a cross-sectional view of the multipart cooling module on the printed circuit board;
- Fig. 5B: shows an enlargement of Fig. 5A; and
- Fig. 6: shows a flow diagram of a method for manufacturing a multipart cooling module for cooling a chip of a rugged computer.

### DETAILED DESCRIPTION

Various examples will now be described more fully with reference to the accompanying drawings in which some examples are illustrated.

Accordingly, while examples are capable of various modifications and alternative forms, the illustrative examples in the figures will herein be described in detail. It should be understood, however, that there is no intent to limit examples to the particular forms disclosed, but on the contrary, examples are to cover all modifications, equivalents, and alternatives falling within the scope of the disclosure. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing illustrative examples only and is not intended to be limiting. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, steps, operations, elements and/or components, but do not preclude the presence or addition of one or more other features, steps, operations, elements, components and/or groups thereof.

Unless otherwise defined, all terms (including technical and scientific terms) used herein have the same meaning as commonly understood by one of ordinary skill in the art to which examples belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

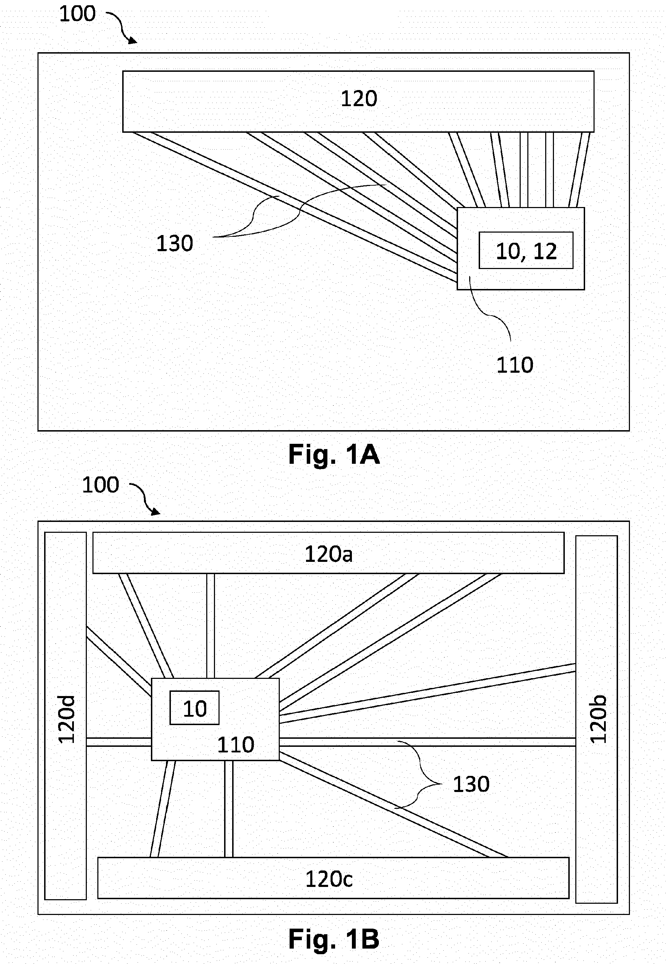

**Fig. 1A** shows a multipart cooling module 100 arrangement, which is suitable for cooling a chip 10 or other electronic components 12 of a rugged computer. The multipart cooling module 100 comprises a first frame 110, a second frame 120 and heat pipes 130. The multipart cooling module 100 can be mounted on a printed circuit board 140.

The first frame 110 may be configured to take heat from the chip 10 of a rugged computer by providing a mounting structure 115 to mount the first frame 110 in thermal contact with the chip 10. In addition, the first frame 110 or thermal contact surface 160 may be in direct physical contact with a heat-generating component, for example with the chip 10 through a TIM 11.

The thermal interface material 11 can be located between the first frame 110 or the thermal contact surface 160 and the chip 10 or other electrical components 12. TIM 11 is a separate component of the multipart cooling module 100, e.g. a foil, paste, liquid, phase-change material, gap filler or similar.

The second frame 120 may be configured to dissipate the heat taken from the first frame 110. The heat pipes 130 may be configured to thermally connect the first frame 110 and second frame 120 to transfer the heat taken from the first frame 110 along the length of the pipes to the second frame 120.

For example, the heat pipes 130 are further configured to be physically and thermally connected to the first frame 110 and to the second frame 120. The heat pipes 130 may serve as a conduit for removing, transferring and/or dissipating heat away from the electronic components (e.g chip 10 or other electronic components 12).

In addition, the heat pipes 130 can have a flat structure between the first frame 110 and to the second frame 120 for example being in the same plane as the first frame 110 and the second frame 120. For example, the height of the multipart cooling module 100 is less than 2 cm, whereas the height of a conventional gaming computer cooling module is 8 - 15 cm or more.

The multipart cooling module 100 can include the same or different number, diameter, length, shape, and/or configuration of heat pipes 130 to increase the heat transfer rate from the first frame 110 to the second frame 120. Therefore, heat pipes 130 may improve the thermal performance by varying the evaporator length, condenser length, capillary structure, pressure and working fluid.

In addition, the multipart cooling module 100 can be located on the edges or in the center of the printed circuit board 140.

**Fig. 1B** shows a multipart cooling module 100 arrangement, which is suitable for cooling a chip 10 or other electronic components 12 of a rugged computer. The multipart cooling module 100 comprises a first frame 110, multiple second frames 120 (120a, 120b, 120c, 120d) and heat pipes 130 connecting the first frame 110 to multiple second frames 120 (120a, 120b, 120c, 120d ...120n). In addition, the heat pipes can connect the first frame 110 to one or more second frames (e.g. 120b to 120d). Within the frame structure of the one or more second frames 120 (120a, 120b ...), the arrangement of the heat pipes 130 may be parallel or non-parallel.

The additional technical effect of the second frames 120 (120a, 120b, 120c, 120d ... 120n) is to cover the heat pipes 130 and the heatsinks 170 and to provide mechanical protection for the embedded heat pipes 130. It is understood that the heat pipes 130 are set firmly into the heatsinks 170.

According to the embodiment of Fig. 1B heat pipes 130 extend in multiple directions away from the chip 10, e. g. in a horizontal and vertical direction of the drawing plane of Fig. 1B. This provides the following advantage. If the rugged computer will be installed on an aerial vehicle such as a combat jet, a high g-force acting in one direction may interrupt the circulation inside heat pipes 130 extending parallel or antiparallel to the g-force, but in the other heat pipes extending in other directions (e.g. perpendicular to the acting g-force). Therefore, the cooling can be maintained even if changing g-forces act in different directions. In addition, the heat can be dissipated over a larger area in the embodiments of Fig. 1B.

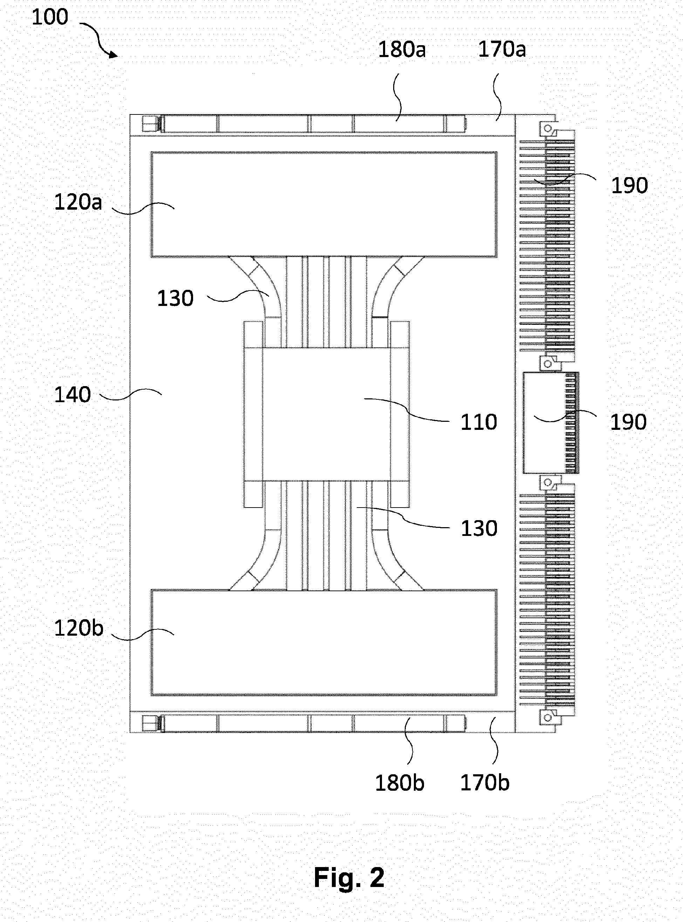

**Fig. 2** shows an exemplary arrangement of the electronic components for a rugged computer device on the front side of the printed circuit board 140.

The shape of the heat pipes 130 can be straight, bent, curved or looped. The heat pipes 130 may be adapted to transfer heat away from the chip 10 and towards the edges of the printed circuit board, for example to heatsinks 170.

The rugged computer device may have one or more heatsinks 170 (170a, 170b...). The one or more heatsinks 170 can be arranged on one or more edges of the printed circuit board 140. The second frame 120 may be adapted to thermally contact the one or more heatsinks 170. The heatsink 170 can provide for example a mechanical clamp that allows the rugged computer module to be attached and detached easily and quickly in an ANSI/VITA compliant chassis.

For example, the fastener 180 can be a threaded fastener, a conventional wedgelock, a thermally enhanced wedgelock, or other suitable wedgelock, which is adapted for integration into a rugged conduction cooled computer or an ANSI/VITA compliant system.

For example, the second frame 120 is one of multiple second frames 120a, 120b. The multiple second frames 120a, 120b may be configured to be coupled to different heatsinks 170a and 170b of the rugged computer.

The number of the second frames 120 (120a, 120b, 120c... 120n), the number of the heatsinks 170 (170a, 170b, 170c...170n), and the number of the fasteners 180 (180a, 180b, 180c...180n) may correlate with one another, and the second frame 120 may be in thermal connection with heatsink 170 and with the fastener 180.

The technical function of the heatsink 170 is to help to disperse the heat transferred from the chip 10 or other heat sources, for example, across outer surfaces of the rugged computer device to the chassis of a rugged conduction cooled system.

The heatsink 170 may be made of any number of materials including, for example, copper, aluminum, silver, another thermally conducting material, or any combination thereof.

The rugged computer device may have one or more connectors 190 for contacting the chip 10. The connectors 190 may be arranged on another edge of the printed circuit board 140.

For example, the at least one heatsink 170 and the connectors 190 are provided at distinct edges of the printed circuit board 140. In addition, the connectors 190 may be adapted to use in ANSI/VITA compliant computer modules.

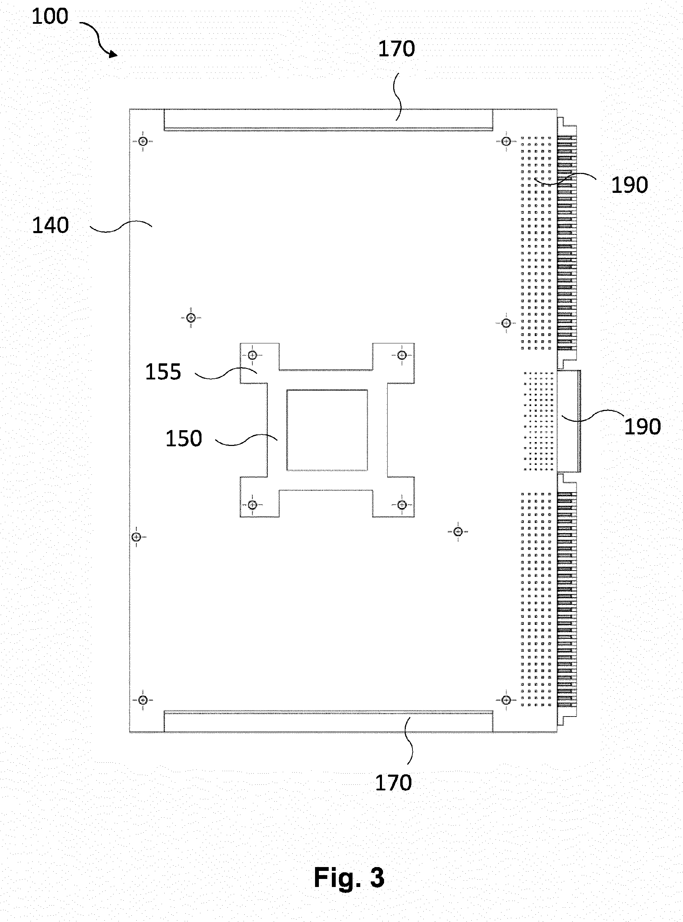

**Fig. 3** shows an exemplary arrangement of the components on the rear side of a printed circuit board 140. The front side of the printed circuit board 140 can be defined as the side on which the mounting of the first frame 110 will be established. The rear side is then the side opposite thereto.

The multipart cooling module 100 may further comprise a stiffener 150, which is mountable on the rear side of the printed circuit board 140. The stiffener 150 may be configured to engage the mounting structure 115 to stiffen the printed circuit board 140 when securing the first frame 110.

The stiffener 150 can be a metal plate (e.g. rigid steel) that further stabilize the first frame 110 and may avoid bending of the printed circuit board 140.

The stiffener 150 may be configured to have one or more receiving structure 155 adapted to selectively receive the mounting structure 115 of the first frame 110. The first frame 110 and the stiffener 150 can be located on the edges or in the center of the printed circuit board 140, in such a way that the mounting structure 115 of the first frame 110 can be selectively secured to the receiving structure 155 of the stiffener 150.

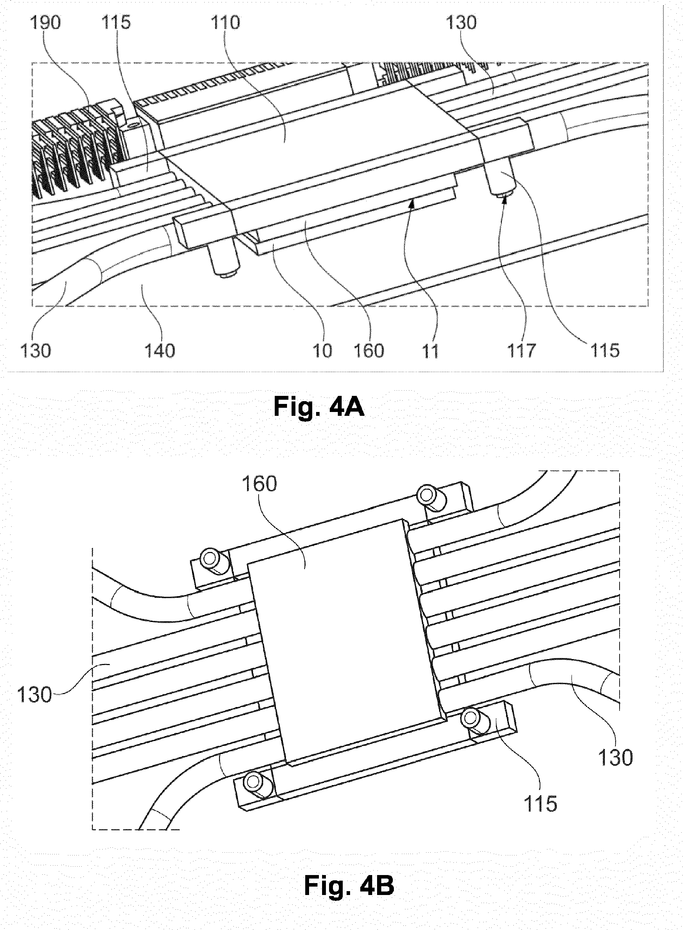

**Fig. 4A** shows a side view of the multipart cooling module 100 on the printed circuit board 140. The mounting structure 115 may be formed to provide a gap 117 to the printed circuit board 140 when mounted on the printed circuit board 140.

For example, the first frame 110 may comprise a thermal contact surface 160 to provide a plane-parallel contact to the chip 10 through a TIM 11 when the multipart cooling module 100 is mounted on the printed circuit board 140.

The thermal interface material 11 can be located between thermal contact surface 160 and the chip 10. The thermal interface material 11 can be for example a foil, paste, liquid, phase-change material, gap filler or similar.

The length of the mounting structure 115 may have a limit for a given chip 10. For example, the greater the height of the chip 10, the greater the length of the mounting structure 115, wherein the length of the mounting structure 115 is less than the height of the chip 10.

The gap 117 between the mounting structure 115 and the printed circuit board 140 may be in the range of 0.1 mm to 10 mm or 3 mm to 5 mm or 0.2 mm to 2 mm.

Therefore, the distance of the first frame 110 from the printed circuit board 140 can be at least as large as the worst-case cascade of tolerances.

For example, the mounting structure 115 may be adapted to provide a detachable connection selected from one of the following: a screw connection, a clip connection, a bayonet connection, a spring mounted connection or other suitable connection.

The mounting structure 115 can be detachable from the printed circuit board 140, therefore the gap 117 between the mounting structure 115 and the printed circuit board 140 can be adjusted. This may include a possible control for overcoming the manufacturing tolerance.

For example, the attaching mechanism of the detachable connection may use screws, sliding clips, bayonet mounts, springs, or other attachment mechanisms to provide a securing and/or releasing the mounting structure 115 to the receiving structure 155 of the stiffener 150 in such way. In this way, the printed circuit board 140 may be located between the first frame 110 and the stiffener 150.

For example, the receiving structure 155 of the stiffener 150 can be threads, slide bars, bayonet connectors, or other mounting surfaces to provide the attaching and detaching of the mounting structure 115 of the first frame 110.

**Fig. 4B** shows an exemplary arrangement of the components on rear side of the multipart cooling module 100. The rear side of the multipart cooling module 100 can be defined as the side on which the chip 10 will be established. The front side is then the side opposite thereto.

For example, the first frame 110 and/or the second frame 120 may include a soldering material, in which the heat pipes 130 can be embedded. During the soldering process, the solder material can be placed or poured on the first frame 110 and/or the second frame 120. The soldering material can fill the space between the frames 110, 120 and the heat pipes 130 as it may flow in in every direction and provide a thermal contact between the components and a completely embedded structure.

The heat pipes 130 can be embedded in the soldering material and positioned between the first frame 110 and the thermal contact surface 160, therefore the heat pipes 130 are completely surrounded with the soldering material. The solder connection between the heat pipes 130 can improve the heat transfer from the chip 10 on the first frame 110 to the second frame 120. In addition, the soldering material may provide a surrounding condition in which the heat pipes 130 operate and may be further adapted to maintain the well-defined physical distance between the heat pipes 130.

With embedded heat pipes 130, the weight of the multipart cooling module 100 can be reduced (lighter cooling module), therefore the overall mass is also reduced compared to a conventional cooling module with similar or worse thermal performance. The heat pipes 130 may be embedded in the metallic first frame 110 in part.

In addition, the mounting structure 115 can be formed to protrude parallel to the heat pipes 130. The heat pipes 130 may be bended to guide the heat over a larger area of the second frame 120. The protruding form of the mounting structure 115 has the technical effect to support a bending of the heat pipes 130. In addition, the parallel extending mounting structure 115 provide the technical effect that thermal stresses can be mitigated. This parallel extension provides a horizontal gap between the mounting hole through the PCB and the chip 10 so that a thermal expansion of the chip 10 and/or of the thermal contact surface 160 can be absorbed by a slight bending of the printed circuit board 140, the mounting structure 115 or the TIM 11.

In severe environments, for example with strong vibration or shock, it is desired to hold the heat pipes 130 in an axial position with respect to the first frame 110 and minimizing the possible longitudinal, lateral and/or vertical movements, caused by the external environment.

In addition, in extreme weather conditions (e.g. wind, snow, ice, humidity, sand, rain, cold, heat, direct sunlight etc.), harsh environments (e.g. mechanical shocks, vibrations, extreme fluctuations of temperature) or other situations may occur where the proper operation of the multipart cooling module 100 of the rugged computer device is of the utmost importance.

Therefore, it becomes possible the ANSI/VITA compliant rugged computer device with the multipart cooling module 100 to operate within a controlled office environment as well as in extreme or harsh environmental conditions.

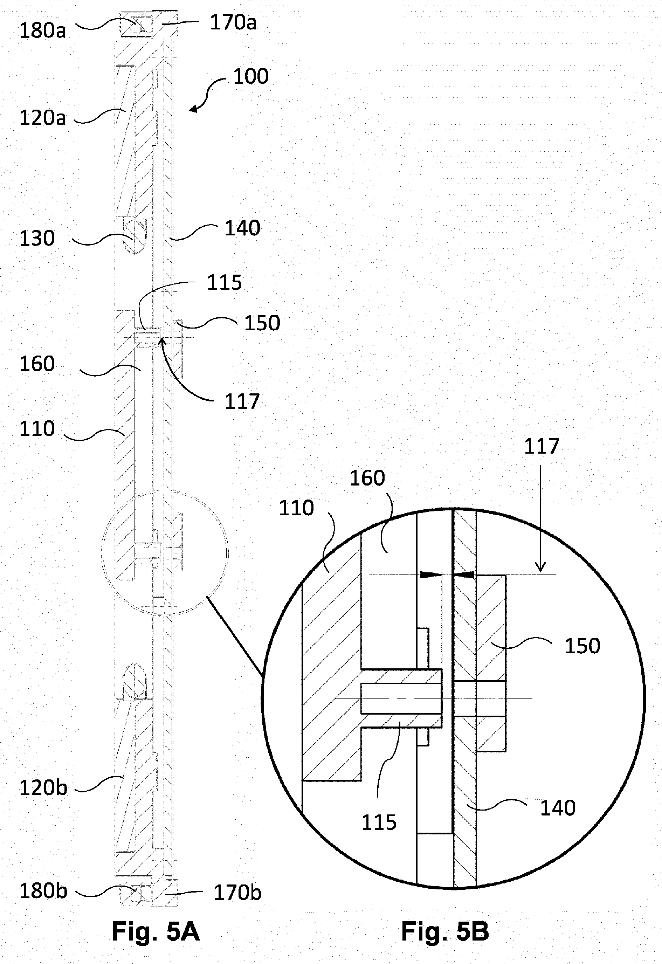

**Fig. 5A** shows a cross-sectional view of the multipart cooling module 100 on printed circuit board 140 and **fig. 5B** shows an enlargement of Fig. 5A.

The first frame 110, the second frames 120 (120a, 120b, ...), and the heat pipes 130 can be the loosely coupled components of the multipart cooling module 100. As a result, for the loose coupled first frame 110 to be effective the distance of the first frame 110 from the printed circuit board 140 can be at least as large as the worst-case cascade of tolerances which among others is defined by the actual height and tilt of the electronic component.

The first frame 110, the second frames 120 (120a, 120b, ...), and the heat pipes 130 can be the independent part of the rugged computer module. The loosely coupled components of the multipart frame 100 can for example enable adding components, removing components, or rearranging the way in which components can also be interconnected.

In order to optimize spread of the heat and transition to the heat pipes 130 using highly conductive material like copper for the first frame 110 is a relevant consideration. Thermal simulation can provide the optimal dimensions for the first frame 110 as well as options for the material for a specific implementation. For example, the material of the second frame 120 can be an aluminum alloy or other lightweight material instead of copper for weight considerations.

In addition, the material of the first frame 110 and the second frame 120 can be a high strength aluminum metal or other lightweight material adapted to conforming to standards for rugged computing devices.

For example, in an avionic, industrial, space, maritime or military environment in contrast to normal compute, it is of an advantage to use lightweight materials for the first frame 110 and for the second frame 120 of the multipart cooling module 100 to reduce overall system weight. In addition, the material of the first frame 110 and the second frame 120 may also offer good thermal conductive properties.

The distance (e.g. gap 117) between the mounting structure 115 of the first frame 110 and the printed circuit board 140 may allow to compensate for manufacturing tolerances and thus for an optimized thermal contact between the chip 10 and the corresponding multipart cooling module 100.

Further embodiments may optimize the flow of thermal energy from the chip 10 to the fastener 180 (e.g. wedgelock) or chassis/heatsink by minimizing the distance between the chip 10 and the fastener 180 or chassis/heatsink. This can achieved by building the multipart cooling module 100 out of separate components that are connected using heat pipes 130.

The elasticity of heat pipes 130 may allow to compensate for manufacturing tolerances and thus for an optimized thermal contact between the chip 10 and the corresponding the second frame 120.

Fixing the first frame 110 with strictly torque controlled screws may allow to perfectly mate the heat conducting surfaces of the multipart cooling module 100, heatsink 170 and the electronic component (e.g. chip 10) using high performance thin thermal interface material 11. Alternatively, springs can be used for pressure control. In order to further optimize the thermal transition, it may be recommended to strictly control surface roughness when milling the mating surface of the first frame 110.

The heat sinks 170a, 170b may be interposed between the second frame 120 and the fastener 180 and/or a support that holds the rugged computer device (e.g. a support frame) and comprises a light material of high thermal conductivity (such as aluminum) to dissipate the heat via the support frame into the surrounding. If the fastener 180 is a wedge lock it will ensure a direct (thermal) and large contact of the wedge lock 180, and possibly also of the heat sinks 170a, 170b, to the support frame.

Embodiments use this heat dissipation in computer systems that include, for example, multiple slot-like computer devices that are arranged in parallel slots and that are ventilation-free, i.e. dissipate heat only via heat conduction and/or radiation (e.g. from the support frame).

**Fig. 5B****,** which is the enlargement of Fig. 5A, illustrates a distance or a gap 117 based on the worst-case tolerance. In particular, fig. 5B is an extract drawing showing the rugged computer element which may allow for tolerance compensation. The heat pipes 130 holding in place the elastically mounted first frame 110, which front view is shown on fig.5A. The technical effect of using the stiffener or backplate 150 is to stabilize the elastically mounted first frame 110 from the opposite side of the printed circuit board 140.

Because of the reduced distance (e.g. gap 117) between the chip 10 and the printed circuit board 140, the conventional thick thermal interface material (TIM) can be replaced with a thinner and considerably more efficient TIM 11. For example, the multipart cooling module 100 can be adapted in a 6U VME Compute Module.

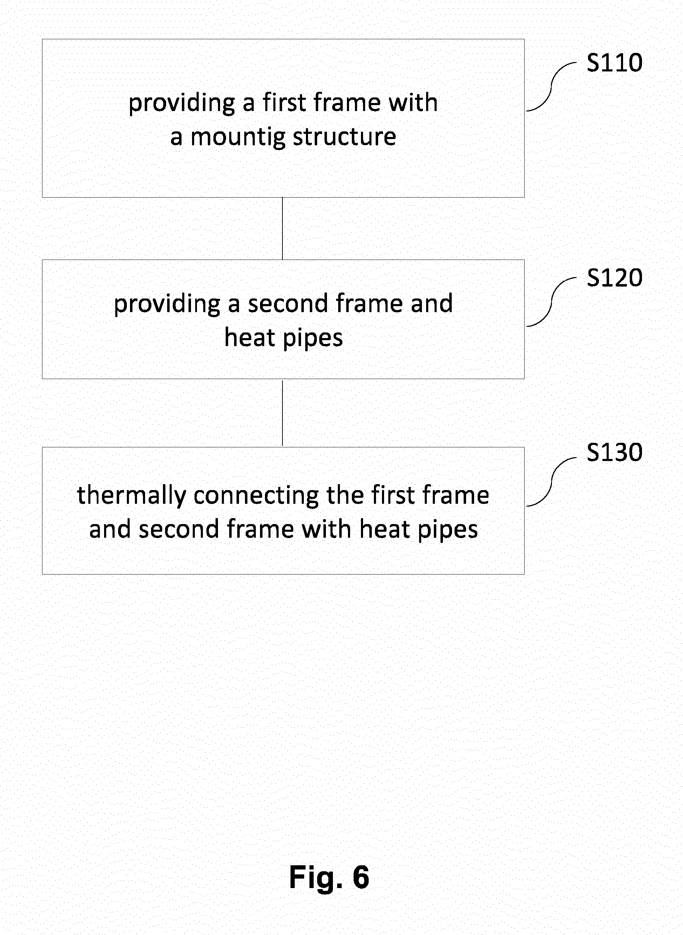

**Fig. 6** shows a flow diagram of a method for manufacturing a multipart cooling module 100 for cooling a chip 10 of a rugged computer. The method comprises the steps of:
- providing S110 a first frame 110 with a mounting structure 115 to mount the first frame 110 in thermal contact with the chip 10 of the rugged computer;
- providing S120 a second frame 120 and heat pipes 130; and
- thermally connecting S130 the first frame 110 and second frame 120 with heat pipes 130 to transfer the heat taken from the first frame 110 to the second frame 120.

In addition, the method for manufacturing a multipart cooling module 100 for cooling a chip 10 of a rugged computer may further comprises the following steps:
- embedding the heat pipes 130 in soldering material in the first frame 110;
- embedding the heat pipes 130 in soldering material in the second frame 120;
- embedding the heat pipes 130 in other high thermal conductive materials like paste, TIM or thermal glue.

According to further embodiment, the extraction of heat from the chip 10 to the fastener 180 (e.g. wedgelock) may be optimized by using very thin TIM 11 between the thermal contact surface 160 and the chip 10 such that there is no air gap between the surfaces. In addition, the first frame 110 which is providing the thermal contact surface 160 is also in direct contact to the heat pipes 130.

This advantageous effect can be achieved by building the multipart cooling module 100 out of separate components that are connected using elastic heat pipes 130.

The rugged computer device may be configured to be in compliance with the ANSI/VITA requirements and can be widely used, where embedded computing is required, such as military, aerospace, industrial, avionic or maritime system, radar, or in other harsh environments.

In comparison to conventional systems, embodiments provide the following advantages:
- superior cooling performance allows for superior compute performance;
- allow to use thinner high performance thermal interface material;
- provide equal pressure distribution between the electronic component and the heatsink for optimized thermal contact;
- lower weight compared to monolithic metal heatsinks;
- cost optimizations as electronic components and chips can be used which aggregate more features into a single device;
- increased longevity of the electronics due to decreased operating temperature of electronic devices;
- size, weight and power (SWAP) optimizations in electronic devices;
- superior thermal performance in direct comparison to the conventional thermal solution based on the same conditions;
- useable in rugged conduction cooled computers using ANSI/VITA compliant computer modules and other rugged computer modules.

There are conventional heatsinks for rugged conduction cooled ANSI/VITA compliant compute modules, which are monolithic heatsinks with embedded heat pipes.

Conventional cooling solutions for ANSI/VITA compliant rugged conduction cooled computer modules use a monolithic frame approach consisting of a highly thermally conductive metal like aluminum alloys or copper.

However, these conventional monolithic heatsinks use the heat pipes only to distribute the heat in an improved fashion over the heatsink. Due to the monolithic nature of the heatsink no additional gains can be achieved by optimizing the thermal contact between the hot electronic chip and the heatsink.

The description and drawings merely illustrate the principles of the disclosure. It will thus be appreciated that those skilled in the art will be able to devise various arrangements that, although not explicitly described or shown herein, embody the principles of the disclosure and are included within its scope.

Furthermore, while each embodiment may stand on its own as a separate example, it is to be noted that in other embodiments the defined features can be combined differently, i.e. a particular feature described in one embodiment may also be realized in other embodiments. Such combinations are covered by the disclosure herein, unless it is stated that a specific combination is not intended.

### List of reference signs

- 10: (computer) chip
- 11: thermal interface material (TIM)
- 12: electronic components
- 100: multipart cooling module
- 110: first frame
- 115: mounting structure
- 117: gap
- 120: second frame
- 120a, 120b...: multiple second frames
- 130: heat pipes
- 140: printed circuit board (PCB)
- 150: stiffener or backplate
- 155: receiving structure
- 160: thermal contact surface
- 170: heatsink
- 170a, 170b...: multiple heatsinks
- 180: fastener (e.g. wedgelock)
- 180a, 180b...: multiple fasteners
- 190: connectors

## Claims

1. A multipart cooling module (100) for cooling a chip (10) of a rugged computer, the multipart cooling module (100) comprising:
a first frame (110) configured to take heat from the chip (10) of the rugged computer by providing a mounting structure (115) to mount the first frame (110) in thermal contact with the chip (10);
a second frame (120) configured to dissipate the heat taken from the first frame (110); and
heat pipes (130), thermally connecting the first frame (110) and second frame (120) to transfer the heat taken from the first frame (110) to the second frame (120).

2. The multipart cooling module (100) of claim 1, wherein the rugged computer comprises a printed circuit board (140) and the mounting structure (115) is configured to secure the first frame (110) to the printed circuit board (140), the multipart cooling module (100) further comprises:
a stiffener (150), mountable on a rear side of the printed circuit board (140) and configured to engage the mounting structure (115) to stiffen the printed circuit board (140) when securing the first frame (110).

3. The multipart cooling module (100) according to claim 2,
wherein the mounting structure (115) is formed to provide a gap (117) between the mounting structure (115) and the printed circuit board (140) when mounted on the printed circuit board (140),
and wherein the first frame (110) comprises a thermal contact surface (160) to provide a plane-parallel contact to the chip (10) through a thermal interface material (11) when the multipart cooling module (100) is mounted on the printed circuit board (140).

4. The multipart cooling module (100) according to claim 3, wherein the mounting structure (115) is adapted to provide a detachable connection selected from one of the following: a screw connection, a clip connection, a bayonet, a spring mounted connection.

5. The multipart cooling module (100) according to one of the preceding claims, wherein the first frame (110) and/or the second frame (120) include a soldering material, in which the heat pipes (130) are embedded.

6. The multipart cooling module (100) according to one of the preceding claims, wherein the mounting structure (115) is formed to protrude parallel to the heat pipes (130).

7. The multipart cooling module (100) according to one of the preceding claims, wherein the second frame (120) is one of multiple second frames (120a, 120b), the multiple second frames (120a, 120b, ...) are configured to cover different heatsinks (170a, 170b, ...), and the different heatsinks (170a, 170b, ...) are configured to couple to different fasteners (180a, 180b, ...) of the rugged computer.

8. The multipart cooling module (100) according to one of the preceding claims, wherein the first frame (110) and the second frame (120) are made of a conductive material.

9. The multipart cooling module (100) according to one of the preceding claims, wherein the material of the first frame (110) is copper or another highly thermally conductive material and the material of the second frame (120) is aluminum or an aluminum alloy or another highly thermally conductive material.

10. A rugged computer device for an industrial, avionic, military, space or maritime system, the rugged computer device comprising:
one or more printed circuit board (140) with at least one chip (10) and one or more electronic components (12);
a housing configured to release the heat passively or actively in the environment; and
one or more multipart cooling module (100) according to one of the preceding claims to cool the at least one chip (10).

11. The rugged computer device according to claim 10, further comprising one or more of the following components:
one or more heatsinks (170), arranged at least one edge of the printed circuit board (140) and the second frame (120) being adapted to thermally contact the at least one heatsink (170);
- one or more fasteners (180), arranged at one or more edges of the printed circuit board (140) being adapted to thermally and mechanically contact the one or more heatsinks (170) to the printed circuit board (140);
connectors (190), arranged on an edge of the printed circuit board (140) that is distinct from at least one edge with the at least one heatsink (170).

12. The rugged computer device according to claim 10 or claim 11, which is configured to comply at least one standard for embedded computing systems, by including at least one of the following:
forming the heatsink (170) without relying on forced convection for cooling,
forming the first frame (110) out of conductive material with a thickness of at least the diameter of the heat pipes (130),
forming the thermal contact surface (160) on the first frame (110),
forming the thermal interface material (11) between the thermal contact surface (170) and the chip (10) or other electronic components (12),
using thermal interface material (11) on the thermal contact surface (160) between the first frame (110) and the chip (10) to cool the chip (10),
forming the thermal contact surface (160) in direct contact with the chip (10) through the thermal interface material (11),
forming the heat pipes (130) to operate with temperatures at the heatsink (170) of more than 70°C,
using a mounting structure (115) for the multipart cooling module (100) that withstand one or more of the following: shocks of up to 40 g for 11 ms, half-sine vibrations of up to 0.1 g²/Hz in a range of 5-2000Hz, high relative humidity of up to 95%, multiple g-forces in different directions.

13. An industrial, avionic, space, maritime or military system comprising the rugged computer device according to one of claims 10 to 12.

14. A method for manufacturing a multipart cooling module (100) for cooling a chip (10) of a rugged computer, the method comprising at least one of the following steps:
providing (S110) a first frame (110) with a mounting structure (115) to mount the first frame (110) in thermal contact with the chip (10) of the rugged computer;
providing (S120) a second frame (120) and heat pipes (130); and
thermally connecting (S130) the first frame (110) and second frame (120) with heat pipes (130) to transfer the heat taken from the first frame (110) to the second frame (120).

15. The method of claim 14, further comprising at least one of the following step:
embedding the heat pipes (130) in soldering material in the first frame (no); and/or
embedding the heat pipes (130) in soldering material in the second frame (120); and/or
embedding the heat pipes (130) in other high thermal conductive materials like paste, TIM or thermal glue.

## Amended claims

### Amended claims in accordance with Rule 137(2) EPC.

1. A multipart cooling module (100) for cooling a chip (10) of a rugged computer, the multipart cooling module (100)
**characterized by:**
a first frame (110) configured to take heat from the chip (10) of the rugged computer by providing a mounting structure (115) to mount the first frame (no) in thermal contact with the chip (10);
a second frame (120) configured to dissipate the heat taken from the first frame (110); and
heat pipes (130), thermally connecting the first frame (110) and second frame (120) to transfer the heat taken from the first frame (110) to the second frame (120).

2. The multipart cooling module (100) of claim 1, wherein the rugged computer comprises a printed circuit board (140) and the mounting structure (115) is configured to secure the first frame (110) to the printed circuit board (140), the multipart cooling module (100) further comprises:
a stiffener (150), mountable on a rear side of the printed circuit board (140) and configured to engage the mounting structure (115) to stiffen the printed circuit board (140) when securing the first frame (110).

3. The multipart cooling module (100) according to claim 2,
wherein the mounting structure (115) is formed to provide a gap (117) between the mounting structure (115) and the printed circuit board (140) when mounted on the printed circuit board (140),
and wherein the first frame (110) comprises a thermal contact surface (160) to provide a plane-parallel contact to the chip (10) through a thermal interface material (11) when the multipart cooling module (100) is mounted on the printed circuit board (140).

4. The multipart cooling module (100) according to claim 3, wherein the mounting structure (115) is adapted to provide a detachable connection selected from one of the following: a screw connection, a clip connection, a bayonet, a spring mounted connection.

5. The multipart cooling module (100) according to one of the preceding claims, wherein the first frame (110) and/or the second frame (120) include a soldering material, in which the heat pipes (130) are embedded.

6. The multipart cooling module (100) according to one of the preceding claims, wherein the mounting structure (115) is formed to protrude parallel to the heat pipes (130).

7. The multipart cooling module (100) according to one of the preceding claims, wherein the second frame (120) is one of multiple second frames (120a, 120b), the multiple second frames (120a, 120b, ...) are configured to cover different heatsinks (170a, 170b, ...), and the different heatsinks (170a, 170b, ...) are configured to couple to different fasteners (180a, 180b, ...) of the rugged computer.

8. The multipart cooling module (100) according to one of the preceding claims, wherein the first frame (110) and the second frame (120) are made of a conductive material.

9. The multipart cooling module (100) according to one of the preceding claims, wherein the material of the first frame (110) is copper or another highly thermally conductive material and the material of the second frame (120) is aluminum or an aluminum alloy or another highly thermally conductive material.

10. A rugged computer device for an industrial, avionic, military, space or maritime system, the rugged computer device
**characterized by:**
one or more printed circuit board (140) with at least one chip (10) and one or more electronic components (12);
a housing configured to release the heat passively or actively in the environment; and
one or more multipart cooling module (100) according to one of the preceding claims to cool the at least one chip (10).

11. The rugged computer device according to claim 10, further comprising one or more of the following components:
one or more heatsinks (170), arranged on at least one edge of the printed circuit board (140) and the second frame (120) being adapted to thermally contact the at least one heatsink (170);
- one or more fasteners (180), arranged at one or more edges of the printed circuit board (140) being adapted to thermally and mechanically contact the one or more heatsinks (170) to the printed circuit board (140);
connectors (190), arranged on an edge of the printed circuit board (140) that is distinct from at least one edge with the at least one heatsink (170).

12. The rugged computer device according to claim 10 or claim 11, which is configured to comply with at least one standard for embedded computing systems, by including at least one of the following:
a heatsink (170) formed without relying on forced convection for cooling,
a first frame (110) made of conductive material with a thickness of at least the diameter of heat pipes (130),
a thermal contact surface (160) formed on the first frame (110),
a thermal interface material (11) formed between the thermal contact surface (170) and the chip (10) or other electronic components (12),
the thermal interface material (11) used on the thermal contact surface (160) between the first frame (110) and the chip (10) to cool the chip (10),
the thermal contact surface (160) formed in direct contact with the chip (10) through the thermal interface material (11),
the heat pipes (130) formed at the heatsink (170),
a mounting structure (115) used for the multipart cooling module (100),
wherein the rugged computer device is configured to withstand one or more of the following:
temperatures at the heatsink (170) of more than 70°C, shocks of up to 40 g for 11 ms, half-sine vibrations of up to 0.1 g²/Hz in a range of 5-2000Hz,
high relative humidity of up to 95%, multiple g-forces in different directions.

13. An industrial, avionic, space, maritime or military system comprising the rugged computer device according to one of claims 10 to 12.

14. A method for manufacturing a multipart cooling module (100) for cooling a chip (10) of a rugged computer, the method comprising at least one of the following steps:
providing (Sno) a first frame (110) with a mounting structure (115) to mount the first frame (110) in thermal contact with the chip (10) of the rugged computer;
providing (S120) a second frame (120) and heat pipes (130); and
thermally connecting (S130) the first frame (110) and second frame (120) with the heat pipes (130) to transfer the heat taken from the first frame (110) to the second frame (120).

15. The method of claim 14, further comprising at least one of the following step:
embedding the heat pipes (130) in soldering material in the first frame (110); and/or
embedding the heat pipes (130) in soldering material in the second frame (120); and/or
embedding the heat pipes (130) in other high thermal conductive materials like paste, TIM or thermal glue.
